# EUROPÄISCHE PATENTSCHRIFT

(11) **EP 1 597 945 B1**
(45) Veröffentlichungstag und Bekanntmachung des Hinweises auf die Patenterteilung: **02.08.2006**
(21) Anmeldenummer: 03795946.7
(22) Anmeldetag: 20.12.2003
(51) Int. Cl.: H05K 1/18, H05K 3/32, H05K 3/40

(54) **VERFAHREN ZUM ELEKTRISCHEN KONTAKTIEREN EINES BAUTEILS MIT EINEM FLACHKABEL**
METHOD FOR ELECTRICALLY CONTACTING A COMPONENT TO A FLAT CABLE
PROCEDE POUR ETABLIR UN CONTACT ELECTRIQUE ENTRE UN ELE MENT ET UN CABLE-RUBAN

(30) Priorität: 25.02.2003 DE 10307846
(43) Veröffentlichungstag der Anmeldung: 23.11.2005
(73) Patentinhaber: DaimlerChrysler AG, 70567 Stuttgart (DE)
(72) Erfinder: BIERBAUM, Gerd, 72644 Oberboihingen (DE)
(86) Internationale Anmeldenummer: PCT/EP2003/014683
(87) Internationale Veröffentlichungsnummer: WO 2004/077900

(56) Entgegenhaltungen:
- DE-A- 10 019 410
- DE-A- 10 111 371
- GB-A- 2 124 433
- US-A- 5 278 385
- US-A- 5 669 775
- US-A- 5 912 435
- PATENT ABSTRACTS OF JAPAN vol. 1997, no. 12, 25. Dezember 1997 (1997-12-25) -& JP 09 204940 A (FUJIKURA LTD), 5. August 1997 (1997-08-05)
- PATENT ABSTRACTS OF JAPAN vol. 2002, no. 05, 3. Mai 2002 (2002-05-03) -& JP 2002 025641 A (HITACHI CABLE LTD), 25. Januar 2002 (2002-01-25)
- PATENT ABSTRACTS OF JAPAN vol. 1999, no. 12, 29. Oktober 1999 (1999-10-29) -& JP 11 195747 A (MATSUSHITA ELECTRIC IND CO LTD), 21. Juli 1999 (1999-07-21)

## Beschreibung

Die Erfindung betrifft ein Verfahren zum elektrischen Verbinden eines elektrischen bzw. elektronischen Bauteils mit mindestens einer Leiterbahn eines Flachkabels. Flachkabel sind insbesondere als FFC (= Flexible Flat Cable) bzw. als flexible Folienleitungssätze bekannt. Flexible Flachkabel weisen üblicherweise mehrere, parallel nebeneinander verlaufende, flachgewalzte Kupferdrähte bzw. Kupferstreifen als Stromleiter auf, welche an einem Isoliermaterial fixiert und von diesem Isoliermaterial umhüllt sind. Diese Isolierung erfolgt beispielsweise mittels eines Laminier- oder Extrudiervorganges. Aus DE 100 19 410 A1 ist es bekannt, die elektrischen Leiterbahnen des Flachkabels mit einem SMD-Bauteil elektrisch zu kontaktieren. JP 09 204940 A offenbart ein Flachkabel, dessen Isolierschicht an einem Leitungsabschnitt einer Leiterbahn entfernt wird.

Der Erfindung liegt die Aufgabe zugrunde, für die elektrische Kontaktierung eines Bauteils mit mindestens einer Leiterbahn eines Flachkabels ein besonders einfaches Verfahren vorzuschlagen.

Diese Aufgabe wird durch die Merkmalskombination des Anspruches 1 gelöst.

Erfindungsgemäß wird zunächst die Isolierschicht des Flachkabels an einem Leitungsabschnitt einer mit dem elektrischen bzw. elektronischen Bauteil zu kontaktierenden Leiterbahn entfernt. Der abisolierte Leitungsabschnitt wird zur Bildung zweier voneinander getrennter Teilabschnitte durchtrennt. Diese Trennung erfolgt z. B. durch Schneiden oder Stanzen. Vorzugsweise wird beim Durchtrennen des Leitungsabschnittes auch ein Segment des Leiterbahnmaterials entfernt. Zur späteren elektrischen Kontaktierung des Bauteils mit den beiden Teilabschnitten wird das Bauteil an einem Kontaktsegment mindestens eines Teilabschnittes positioniert. Danach kann das Bauteil zumindest mit dem Kontaktsegment, an dem es positioniert wurde, elektrisch kontaktiert werden. In einem weiteren Verfahrensschritt wird das Bauteil mit dem Kontaktsegment des zweiten Teilabschnittes ebenfalls elektrisch kontaktiert.

Aufgrund der Trennung des abisolierten Leitungsabschnittes in zwei Teilabschnitte wirkt das Bauteil in seinem Montageendzustand gewissermaßen als elektrische Überbrückung zwischen beiden Teilabschnitten. Vorteilhaft lassen sich durch eine Vielzahl derartiger Überbrückungen mit entsprechenden Bauteilen ganze elektrische bzw. elektronische Schaltungen realisieren, wie bei herkömmlichen Schaltungen auf Leiterplatten. Mit der Erfindung kann dann auf derartige Leiterplatten verzichtet werden. Vielmehr sind die Bauteile mit dem Flachkabel direkt verbunden. Die Vorbereitung des Flachkabels für die Positionierung bzw. Bestückung der Bauteile, die Positionierung selbst und die elektrische Kontaktierung der Bauteile mit dem Flachkabel können in wenigen Arbeitsgängen vollautomatisch und aufgrund reduzierter Teilezahl kostengünstig und prozesssicher hergestellt werden. Außerdem wirkt der Verzicht auf Leiterplatten umweltfreundlich. Das Recycling von Elektronikschrott wird vereinfacht. Das Entfernen der Isolierschicht des Flachkabels an dem ausgewählten Leitungsabschnitt kann beispielsweise mechanisch mittels eines geeigneten Werkzeuges erfolgen. Vorzugsweise erfolgt das Abisolieren mittels Laser.

Für bestimmte Bauteile ist es ausreichend, das Flachkabel im Bereich des ausgewählten Leitungsabschnittes einseitig, d. h. nur auf einer Flachseite des Flachkabels, abzuisolieren.

Die Maßnahme gemäß Anspruch 3 berücksichtigt Bauteile, die an unterschiedlichen Flachseiten der beiden Teilabschnitte elektrisch kontaktiert werden sollen.

Die Maßnahmen der Ansprüche 4 bis 9 berücksichtigen die unterschiedlichen geometrischen Abmessungen und physikalischen Eigenschaften verschiedener Bauteile. Durch an das jeweilige Bauteil angepasste Biegungen der Teilabschnitte können am Flachkabel auch Bauteile integriert werden, die z. B. eine größere Breite und/oder größere Länge als der abisolierte Leitungsabschnitt aufweisen.

Die Ansprüche 10 bis 16 unterstützen eine zuverlässige elektrische Kontaktierung zwischen dem Bauteil und den Kontaktsegmenten. Das elektrische Verbindungsmittel kann an den Kontaktsegmenten und/oder am Bauteil angebracht werden. Hierzu ist beispielsweise eine galvanische Verzinnung vorgesehen. Vorzugsweise wird auf mindestens ein Kontaktsegment und/oder mindestens eine elektrische Kontaktstelle des Bauteils Lötzinn aufgetragen (Anspruch 16). Das Lötzinn kann in Form von Lotpaste mittels Dispenser oder im Siebdruckverfahren aufgetragen werden. Nach dem Anbringen des elektrischen Verbindungsmittels und der Positionierung des Bauteils erfolgt eine elektrische Verbindung zwischen dem Bauteil und dem jeweiligen Kontaktsegment. Diese elektrische Verbindung wirkt z. B. durch Löten, vorzugsweise durch ein Selektivlötverfahren, wie Kolben-, Laser- oder Lichtlöten, an den Kontaktsegmenten. Alternativ zu einem Lötverfahren können - abhängig vom verwendeten Bauteil - auch Verbindungsverfahren, wie Schweißen oder Kleben mittels elektrisch leitfähigem Kleber, eingesetzt werden.

Die Maßnahme nach Anspruch 17 unterstützt eine prozesssichere Positionierung von Bauteilen am Flachkabel.

Die Erfindung wird anhand der in den Zeichnungen dargestellten Ausführungsbeispiele näher erläutert.

Dabei zeigen:
- Fig. 1: ein abisolierter Leitungsabschnitt eines Flachkabels entsprechend Schnittlinie I-I in Figur 2,
- Fig. 2: eine Draufsicht auf das Flachkabel gemäß Blickrichtung II in Figur 1,
- Fig. 3: ein durchtrennter Leitungsabschnitt eines Flachkabels entsprechend Schnittlinie III-III in Figur 4,
- Fig. 4: eine Draufsicht auf das Flachkabel gemäß Blickrichtung IV in Figur 3,
- Fig. 5: der durchtrennte Leitungsabschnitt gemäß Figur 3 mit positioniertem Bauteil,
- Fig. 6: eine Draufsicht auf das Flachkabel gemäß Blickrichtung VI in Figur 5,
- Fig. 7 - 10: eine weitere Ausführungsform des durchtrennten Leitungsabschnittes mit gebogenen Teilabschnitten und positioniertem Bauteil,
- Fig. 11 - 16: eine weitere Ausführungsform des durchtrennten Leitungsabschnittes mit gebogenen Teilabschnitten und daran positioniertem Bauteil,
- Fig. 17: eine Draufsicht auf das Flachkabel mit daran positionierten Bauteilen gemäß der Ausführungsform der Figur 16.

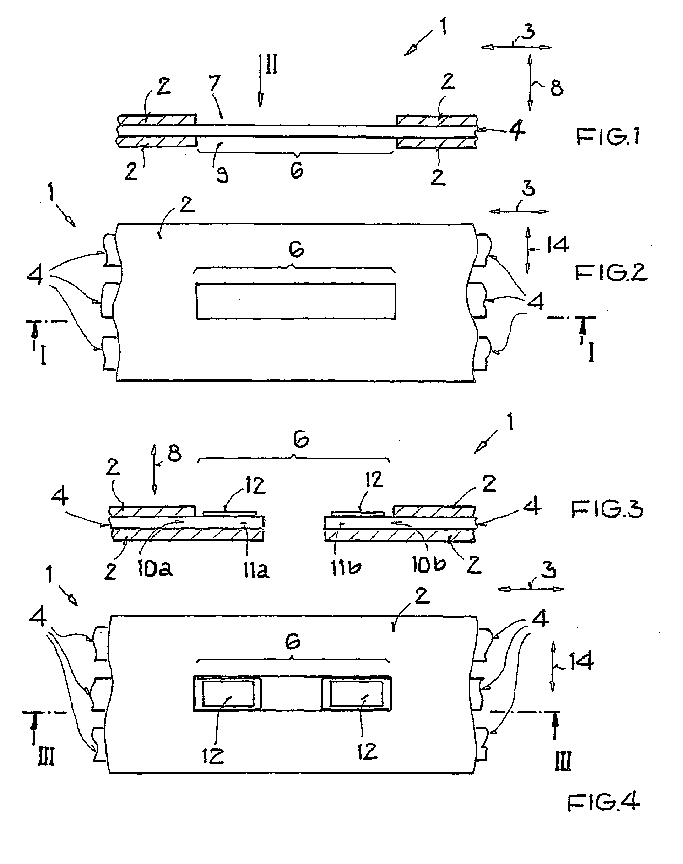

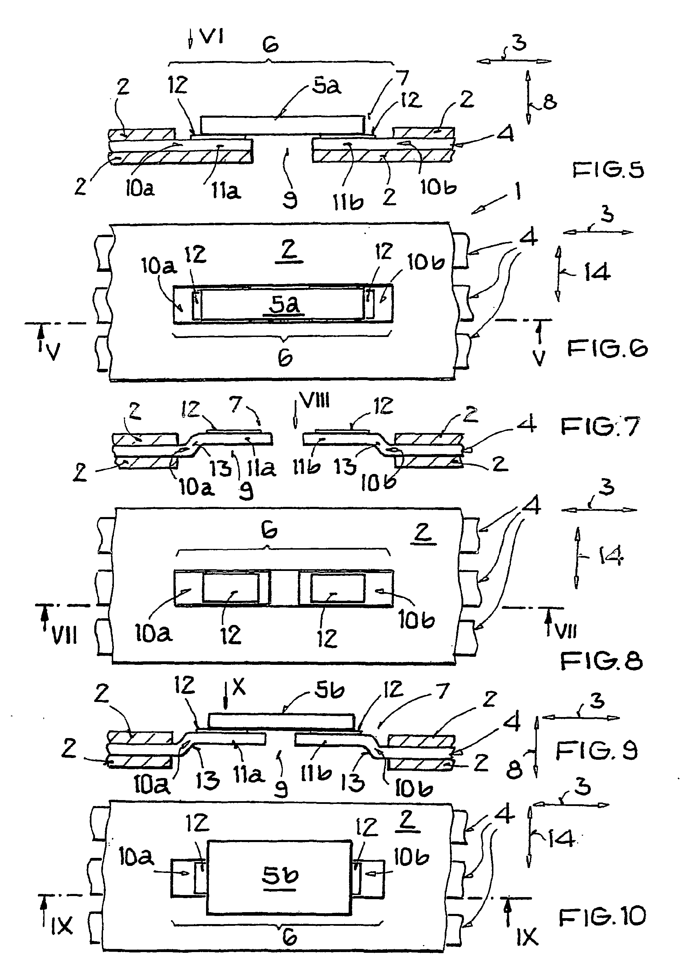

Figur 1 und Figur 2 zeigen ein flexibles Flachkabel 1 mit einer biegsamen Isolierung 2. Diese Isolierung 2 umhüllt insgesamt drei mit Parallellabstand zueinander angeordnete und in Leitungslängsrichtung 3 verlaufende Leiterbahnen 4. Um ein elektrisches bzw. elektronisches Bauteil 5 mit einer Leiterbahn 4 des Flachkabels 1 elektrisch zu verbinden bzw. zu kontaktieren, wird zunächst die Isolierung 2 des Flachkabels 1 an einem ausgewählten Leitungsabschnitt 6 der Leiterbahn 4 entfernt (Figur 1). Dabei ist bei den Ausführungsformen gemäß Figur 1 und Figur 7-16 der Leitungsabschnitt 6 auf beiden, einander gegenüberliegenden Flachseiten - auf einer in Zeichenblattebene betrachtet oberen Flachseite 7 und einer davon in Höhenrichtung 8 gegenüberliegenden unteren Fachseite 9 - des Flachkabels 1 abisoliert. Die Länge des Leitungsabschnittes 6 in Leitungslängsrichtung 3 muss derart gewählt werden, dass das jeweilige Bauteil 5 behinderungsfrei an dem Leitungsabschnitt 6 positioniert werden kann und noch ausreichend Raum für die elektrische Verbindung des Bauteiles 5 ist. Nach dem Abisolieren wird in einem mittleren Bereich des Leitungsabschnittes 6 Leiterbahnmaterial entfernt (z. B. durch Stanzen). Durch dieses Auftrennen des Leitungsabschnittes 6 entstehen zwei voneinander getrennte Teilabschnitte 10a, 10b (z.B. Figur 3). Zwischen den Kontaktsegmenten 11a, 11b beider Teilabschnitte 10a, 10b und dem jeweiligen Bauteil 5 wird ein elektrisches Verbindungsmittel 12 angeordnet.

Bei der Ausführungsform gemäß Figur 3 - Figur 6 wird das Verbindungsmittel 12 an beiden Kontaktsegmenten 11a, 11b angebracht. Vorzugsweise geschieht dies durch Auftragen von Lötzinn in Form von Lotpaste mittels Dispenser. Es kann jedoch auch Leitkleber als elektrisches Verbindungsmittel 12 verwendet werden. Nach dem Anbringen des elektrischen Verbindungsmittels 12 auf die beiden Teilabschnitte 10a, 10b wird das Bauteil 5a an den Kontaktsegmenten 11a, 11b positioniert, z. B. mittels eines Bestückungsautomaten. Nach der Positionierung erfolgt die elektrische Verbindung zwischen dem Bauteil 5a und beiden Kontaktsegmenten 11a, 11b. Dies erfolgt vorzugsweise durch einen Lötvorgang, z. B. ein Selektivlötverfahren, wie Kolben-, Laser- oder Lichtlöten im Bereich des elektrischen Verbindungsmittels 12.

Bei einer zweiten Ausführungsform (Figur 7 - Figur 10) sind beide Teilabschnitte 10a, 10b relativ zur Ebene der zugehörigen Leiterbahn 4 gebogen. Um diese Biegung zu realisieren, ist die Leiterbahn 4 - wie in Figur 1 - sowohl auf der oberen Flachseite 7 als auch auf der unteren Flachseite 9 abisoliert. Beide Teilabschnitte 10a, 10b sind in einem Biegebereich 13 derart gebogen, dass deren Kontaktsegmente 11a, 11b parallel zur Ebene der Isolierung 2 angeordnet sind. Dabei sind die Kontaktsegmente 11a, 11b etwa flächenbündig zur Isolierung 2 an der oberen Flachseite 7 angeordnet. Hierdurch können Bauteile 5 an dem Flachkabel 1 behinderungsfrei positioniert und integriert werden, welche in Leitungslängsrichtung 3 und/oder in Querrichtung 14 eine größere Dimensionierung aufweisen als der Leitungsabschnitt 6. Im Ausführungsbeispiel gemäß Figur 10 weist das Bauteil 5b in Querrichtung 14 eine größere Breite als der Leitungsabschnitt 6 auf. Weiterhin sind die Teilabschnitte 10a, 10b gemäß Figur 7 - Figur 10 derart gebogen, dass deren Kontaktsegmente 11a, 11b nach dem Biegevorgang in derselben Ebene angeordnet sind. Nach dem Biegevorgang werden, wie bei der Ausführungsform gemäß Figur 3 - Figur 6, das elektrische Verbindungsmittel 12 an beiden Kontaktsegmenten 11a, 11b angebracht. Daraufhin wird das Bauteil 5 an beiden Kontaktsegmenten 11a, 11b positioniert und danach mit diesen beiden Kontaktsegmenten 11a, 11b elektrisch verbunden (Figur 9, Figur 10). Hierzu wird vorzugsweise eines der vorgenannten Verbindungsverfahren angewendet.

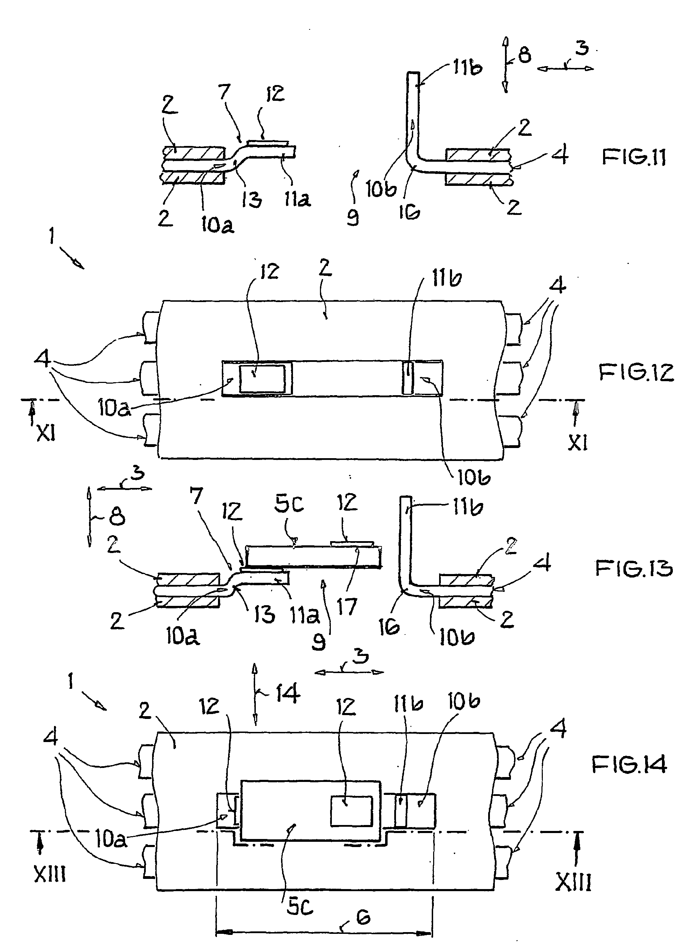

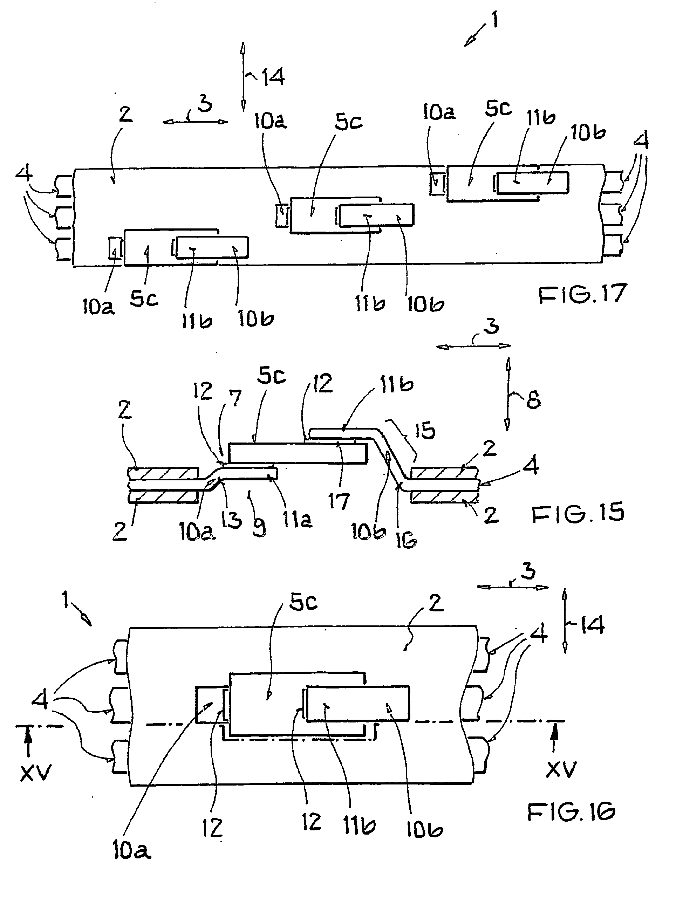

Bei einer weiteren Ausführungsform gemäß Figur 11 - Figur 16 werden die beiden Teilabschnitte 10a, 10b derart gebogen, dass deren Kontaktsegmente 11a, 11b nach dem Biegevorgang in unterschiedlichen Ebenen angeordnet sind (Figur 15). Um den in Figur 15 dargestellten Biegebereich 13 des Teilabschnittes 10a und den Biegeabschnitt 15 zu erzielen, muss die Länge des Leitungsabschnittes 6 in Leitungslängsrichtung 3 entsprechend ausgewählt werden. Nachdem die Isolierung 2 sowohl an der oberen Flachseite 7 als auch an der unteren Flachseite 9 im Bereich des Leitungsabschnittes 6 entfernt wurde, wird der Leitungsabschnitt 6 in die zwei Teilabschnitte 10a, 10b aufgetrennt (Figur 11). Danach wird der Teilabschnitt 10a derart gebogen, dass sein Kontaktsegment 11a etwa flächenbündig zur Isolierung 2 an der oberen Flachseite 7 verläuft. Hierdurch ist gewährleistet, dass das Bauteil 5c etwa plan auf dem Kontaktsegment 11a aufliegt und die danach folgende, elektrische Verbindung ordnungsgemäß durchgeführt werden kann.

In einem weiteren Verfahrensschritt wird der Teilabschnitt 10b umgebogen. Die hierdurch erzeugte Biegung 16 ist derart ausgebildet, dass der Bereich des Kontaktsegments 11b etwa rechtwinklig zur Leitungslängsrichtung 3 und rechtwinklig zur Flachkabelebene, welche durch Leitungslängsrichtung 3 und Querrichtung 14 aufgespannt ist, angeordnet ist (Figur 11). Nach dem Biegen des Teilabschnittes 10b wird das elektrische Verbindungsmittel 12 auf die der oberen Flachseite 7 zugewandte Oberfläche des Kontaktsegments 11a aufgebracht. Alternativ können die beiden Verfahrensschritte des Biegens des Kontaktsegments 11b und des Anbringens des elektrischen Verbindungsmittels 12 am Kontaktsegment 11a auch in umgekehrter Reihenfolge ablaufen. Die umgekehrte Reihenfolge der beiden Verfahrensschritte ist z. B. vorteilhaft, wenn das elektrische Verbindungsmittel (z. B. Lötpaste) mittels Siebdruck aufgebracht wird, was insbesondere bei einer größeren Anzahl von zu positionierenden Bauteilen 5c der Fall sein kann.

Nach diesen beiden vorgenannten Verfahrensschritten wird das Bauteil 5c an dem Kontaktsegment 11a positioniert und mit diesem Kontaktsegment 11a über das elektrische Verbindungsmittel 12 elektrisch kontaktiert (Figur 13). Bei dieser Ausführungsform wird im Unterschied zu den vorgenannten Ausführungsformen am Kontaktsegment 11b kein elektrisches Verbindungsmittel 12 angebracht. Vielmehr wird das elektrische Verbindungsmittel an einer mit dem Kontaktsegment 11b korrespondierenden, elektrischen Kontaktstelle 17 des Bauteils 5c angebracht. Daraufhin wird der Biegeabschnitt 15 des Teilabschnittes 10b derart gebogen, dass das Kontaktsegment 11b unter Zwischenlage des elektrischen Verbindungsmittels 12 etwa plan auf dem Bauteil 5c aufliegt (Figur 15). Dabei sind die beiden Kontaktsegmente 11a, 11b in unterschiedlichen Ebenen etwa parallel zueinander angeordnet. Wurde der Teilabschnitt 10b gemäß Figur 15 gebogen, können das Kontaktsegment 11b und die elektrische Kontaktstelle 17 des Bauteils 5c miteinander elektrisch verbunden werden.

Unterschiedliche Bauteile 5a, 5b, 5c können selbstverständlich an einer Leiterbahn 4 oder auch an mehreren Leiterbahnen 4 desselben Flachkabels 1 positioniert und elektrisch kontaktiert sein. Sie können in Leitungslängsrichtung 3 an unterschiedlichen Stellen angeordnet sein. Bei den in Figur 17 dargestellten Abschnitt des Flachkabels 1 sind insgesamt drei Bauteile 5c an jeweils einer Leiterbahn 4 des Flachkabels 1 integriert.

Es sei darauf verwiesen, dass die in den Zeichnungen dargestellten technischen Details nicht notwendigerweise maßstabsgetreu sind.

## Patentansprüche

1. Verfahren zum elektrischen Kontaktieren eines elektrischen Bauteils (5a, 5b, 5c) mit mindestens einer Leiterbahn (4) eines Flachkabels (1), wobei zunächst die Isolierschicht (2) des Flachkabels (1) an einem Leitungsabschnitt (6) der Leiterbahn (4) entfernt wird,
**gekennzeichnet durch** folgende Verfahrensschritte:
- nach dem Entfernen der Isolierschicht (2) wird der abisolierte Leitungsabschnitt (6) zur Bildung zweier voneinander getrennter Teilabschnitte (10a, 10b) durchtrennt,
- das Bauteil (5a, 5b, 5c) wird an einem Kontaktsegment (11a, 11b) mindestens eines Teilabschnittes (10a, 10b) positioniert,
- das Bauteil (5a, 5b, 5c) wird mit den Kontaktsegmenten (11a, 11b) der Teilabschnitte (10a, 10b) elektrisch kontaktiert.

2. Verfahren nach Anspruch 1,
**dadurch gekennzeichnet , dass** die Abisolierung mittels Laser erfolgt.

3. Verfahren nach Anspruch 1 oder 2,
**dadurch gekennzeichnet , dass** der Leitungsabschnitt (6) auf beiden einander gegenüberliegenden Flachseiten (7, 9) des Flachkabels (1) abisoliert wird.

4. Verfahren nach einem der vorhergehenden Ansprüche,
**dadurch gekennzeichnet ,**
**dass** mindestens ein Teilabschnitt (10a, 10b) relativ zur Ebene der zugehörigen Leiterbahn (4) gebogen wird.

5. Verfahren nach Anspruch 4,
**dadurch gekennzeichnet ,**
**dass** der Teilabschnitt (10a, 10b) derart gebogen wird, dass dessen Kontaktsegment (11a, 11b) etwa parallel zur Isolierschicht (2) angeordnet ist.

6. Verfahren nach Anspruch 5,
**dadurch gekennzeichnet ,**
**dass** das Kontaktsegment (11a, 11b) nach dem Biegevorgang etwa flächenbündig zur Isolierschicht (2) angeordnet ist.

7. Verfahren nach einem der Ansprüche 4 - 6,
**dadurch gekennzeichnet ,**
- **dass** beide Teilabschnitte (10a, 10b) gebogen werden und
- **dass** deren Kontaktsegmente (11a, 11b) nach dem Biegevorgang in derselben Ebene angeordnet sind.

8. Verfahren nach einem der Ansprüche 4 - 6,
**dadurch gekennzeichnet ,**
- **dass** beide Teilabschnitte (10a, 10b) gebogen werden und
- **dass** deren Kontaktsegmente (11a, 11b) nach dem Biegevorgang in unterschiedlichen Ebenen angeordnet sind.

9. Verfahren nach einem der Ansprüche 4 - 8,
**dadurch gekennzeichnet,**
**dass** mindestens ein Teilabschnitt (10a, 10b) vor der Positionierung des Bauteils (5a, 5b, 5c) gebogen wird.

10. Verfahren nach einem der vorhergehenden Ansprüche,
**dadurch gekennzeichnet ,**
**dass** zwischen den Kontaktsegmenten (11a, 11b) beider Teilabschnitte (10a, 10b) und dem Bauteil (5a, 5b, 5c) ein elektrisches Verbindungsmittel (12) zur elektrischen Kontaktierung angeordnet wird.

11. Verfahren nach Anspruch 10,
**dadurch gekennzeichnet ,**
**dass** das Verbindungsmittel (12) an dem Kontaktsegment (11a, 11b) mindestens eines Teilabschnittes (10a, 10b) angebracht wird.

12. Verfahren nach Anspruch 10 oder 11,
**dadurch gekennzeichnet,**
**dass** das Verbindungsmittel (12) nach dem Biegen des Teilabschnittes (10a, 10b) an dessen Kontaktsegment (11a, 11b) angebracht wird.

13. Verfahren nach einem der Ansprüche 10 - 12,
**dadurch gekennzeichnet,**
**dass** das Verbindungsmittel (12) an dem Kontaktsegment (11a) eines einzigen Teilabschnittes (10a) angebracht wird.

14. Verfahren nach einem der Ansprüche 10 - 13,
**dadurch gekennzeichnet,**
**dass** das Bauteil (5a, 5b, 5c) nach dem Anbringen des Verbindungsmittels (12) am Kontaktsegment (11a, 11b) eines Teilabschnittes (10a, 10b) an diesem Kontaktsegment (11a, 11b) positioniert wird.

15. Verfahren nach einem der Ansprüche 10 - 14,
**dadurch gekennzeichnet ,**
**dass** das Verbindungsmittel (12) an mindestens einer mit einem Kontaktsegment (11b) korrespondierenden elektrischen Kontaktstelle (17) des Bauteils (5c) angebracht wird.

16. Verfahren nach einem der Ansprüche 10 - 15,
**gekennzeichnet durch**
Lötzinn als Verbindungsmittel (12).

17. Verfahren nach einem der vorhergehenden Ansprüche,
**dadurch gekennzeichnet,**
**dass** das Bauteil (5a, 5b, 5c) mittels eines Bestückungsautomaten positioniert wird.

## Claims

1. Method for electrically contacting an electrical component (5a, 5b, 5c), to at least one conductor track (4) of a flat cable (1), firstly the insulating layer (2) of the flat cable (1) being removed from a conductor section (6) of the conductor track (4),
**characterized by** the following method steps:
- after the removal of the insulating layer (2), the stripped conductor section (6) is severed to form two separate sub-sections (10a, 10b),
- the component (5a, 5b, 5c) is positioned on a contact segment (11a, 11b) of at least one sub-section (10a, 10b),
- the component (5a, 5b, 5c) is electrically contacted to the contact segments (11a, 11b) of the sub-sections (10a, 10b).

2. Method according to Claim 1, **characterized in that** the stripping is performed by means of a laser.

3. Method according to Claim 1 or 2, **characterized in that** the conductor section (6) is stripped on both, opposite flat sides (7, 9) of the flat cable (1).

4. Method according to one of the preceding claims, **characterized in that** at least one sub-section (10a, 10b) is bent in relation to the plane of the associated conductor track (4).

5. Method according to Claim 4, **characterized in that** the sub-section (10a, 10b) is bent in such a way that its contact segment (11a, 11b) is arranged approximately parallel to the insulating layer (2).

6. Method according to Claim 5, **characterized in that** the contact segment (11a, 11b) is arranged approximately flush with the surface of the insulating layer (2) after the bending operation.

7. Method according to one of Claims 4 - 6,
**characterized**
- **in that** both sub-sections (10a, 10b) are bent and
- **in that** their contact segments (11a, 11b) are arranged in the same plane after the bending operation.

8. Method according to one of Claims 4 - 6,
**characterized**
- **in that** both sub-sections (10a, 10b) are bent and
- **in that** their contact segments (11a, 11b) are arranged in different planes after the bending operation.

9. Method according to one of Claims 4 - 8, **characterized in that** at least one sub-section (10a, 10b) is bent before the positioning of the component (5a, 5b, 5c).

10. Method according to one of the preceding claims, **characterized in that** an electrical connecting means (12) for the electrical contacting is arranged between the contact segments (11a, 11b) of the two sub-sections (10a, 10b) and the component (5a, 5b, 5c).

11. Method according to Claim 10, **characterized in that** the connecting means (12) is provided on the contact segment (11a, 11b) of at least one sub-section (10a, 10b).

12. Method according to Claim 10 or 11, **characterized in that** the connecting means (12) is provided on the contact segment (11a, 11b) of the sub-section (10a, 10b) after the bending of the latter.

13. Method according to one of Claims 10 - 12, **characterized in that** the connecting means (12) is provided on the contact segment (11a) of a single sub-section (10a).

14. Method according to one of Claims 10 - 13, **characterized in that** the component (5a, 5b, 5c) is positioned on the contact segment (11a, 11b) of a sub-section (10a, 10b) after the connecting means (12) has been provided on this contact segment (11a, 11b).

15. Method according to one of Claims 10 - 14, **characterized in that** the connecting means (12) is provided at at least one electrical contact point (17) of the component (5c) corresponding to a contact segment (11b).

16. Method according to one of Claims 10 - 15, **characterized by** soldering tin as the connecting means (12).

17. Method according to one of the preceding claims, **characterized in that** the component (5a, 5b, 5c) is positioned by means of an automatic placement machine.

## Revendications

1. Procédé pour la mise en contact électrique d'un composant électrique (5a, 5b, 5c), avec au moins une piste conductive (4) d'un câble plat (1), au cours duquel, dans un premier temps, on retire la couche isolante (2) du câble plat (1) sur un tronçon de ligne (6) de la piste conductive (4) ; **caractérisé par** les étapes de procédé suivantes :
- après avoir ôté la couche isolante, on sectionne le tronçon de ligne dénudé (6) pour former deux sections partielles séparées l'une de l'autre (10a, 10b),
- on positionne le composant (5a, 5b, 5c) sur un segment de contact (11a, 11b) d'au moins une section partielle (10a, 10b),
- on met le composant (5a, 5b, 5c) en contact électrique avec les segments de contact (11a, 11b) des sections partielles (10a, 10b).

2. Procédé selon la revendication 1, **caractérisé en ce qu'**on procède au dénudage par laser.

3. Procédé selon la revendication 1 ou 2, **caractérisé en ce qu'**on dénude le tronçon de ligne (6) sur les deux côtés plats opposés (7, 9) du câble plat (1).

4. Procédé selon l'une quelconque des revendications précédentes, **caractérisé en ce qu'**on recourbe au moins une section partielle (10a, 10b) par rapport au plan de la piste conductive correspondante (4).

5. Procédé selon la revendication 4, **caractérisé en ce qu'**on recourbe la section partielle (10a, 10b) de façon à ce que son segment de contact (11a, 11b) soit disposé approximativement à la parallèle de la couche isolante (2).

6. Procédé selon la revendication 5, **caractérisé en ce qu'**après avoir été recourbé, le segment de contact (11a, 11b) est disposé approximativement à surface plane avec la couche isolante (2).

7. Procédé selon l'une quelconque des revendications 4 à 6, **caractérisé en ce que** :
- l'on recourbe les deux sections partielles (10a, 10b) et
- **en ce qu'**après avoir été recourbés, leurs segments de contact (11a, 11b) sont disposés dans le même plan.

8. Procédé selon l'une quelconque des revendications 4 à 6, **caractérisé en ce que** :
- l'on recourbe les deux sections partielles (10a, 10b) et
- **en ce qu'**après avoir été recourbés, leurs segments de contact (11a, 11b) sont disposés dans des plans différents.

9. Procédé selon l'une quelconque des revendications 4 à 8, **caractérisé en ce qu'**on recourbe au moins une section partielle (10a, 10b) avant de positionner le composant (5a, 5b, 5c).

10. Procédé selon l'une quelconque des revendications précédentes, **caractérisé en ce qu'**on dispose un moyen de liaison électrique (12) pour la mise en contact électrique entre les segments de contact (11a, 11b) des deux sections partielles (10a, 10b) et le composant (5a, 5b, 5c).

11. Procédé selon la revendication 10, **caractérisé en ce qu'**on monte le moyen de liaison (12) sur le segment de contact (11a, 11b) d'au moins une section partielle (10a, 10b).

12. Procédé selon la revendication 10 ou 11, **caractérisé en ce qu'**après avoir recourbé la section partielle (10a, 10b), on monte le moyen de liaison (12) sur le segment de contact (11a, 11b) de cette dernière.

13. Procédé selon l'une quelconque des revendications 10 à 12, **caractérisé en ce qu'**on monte le moyen de liaison (12) sur le segment de contact (11a) d'une seule section partielle (10a).

14. Procédé selon l'une quelconque des revendications 10 à 13, **caractérisé en ce qu'**après le montage du moyen de liaison (12) sur le segment de contact (11a, 11b) d'une section partielle (10a,10b), on positionne le composant (5a, 5b, 5c) sur le segment de contact (11a,11b) de cette dernière.

15. Procédé selon l'une quelconque des revendications 10 à 14, **caractérisé en ce qu'**on monte le moyen de liaison (12) sur au moins un point de contact électrique (17) du composant (5c) correspondant avec un segment de contact (11b).

16. Procédé selon l'une quelconque des revendications 10 à 15, **caractérisé par** de l'étain de brasage en tant que moyens de liaison (12).

17. Procédé selon l'une quelconque des revendications précédentes, **caractérisé en ce qu'**on positionne le composant (5a, 5b, 5c) au moyen d'un automate à équiper.
